Europäisches Patentamt

European Patent Office

Office européen des brevets

(11) Veröffentlichungsnummer: **0 028 685**

**A2**

(12) **EUROPÄISCHE PATENTANMELDUNG**

(21) Anmeldenummer: **80105329.9**

(22) Anmeldetag: **06.09.80**

(51) Int. Cl.³: **H 01 L 27/08**
**H 03 K 17/08**

(30) Priorität: **09.11.79 DE 2945273**

(43) Veröffentlichungstag der Anmeldung:
**20.05.81 Patentblatt 81/20**

(84) Benannte Vertragsstaaten:
**AT CH DE FR GB IT LI NL SE**

(71) Anmelder: **ROBERT BOSCH GMBH**
**Postfach 50**
**D-7000 Stuttgart 1(DE)**

(72) Erfinder: **Gademann, Lothar, Dipl.-Ing.**
**Sülchenstrasse 42**
**D-7407 Rottenburg(DE)**

(54) **Darlington-Transistorschaltung.**

(57) Es wird eine Darlington-Transistorschaltung mit einem Endstufentransistor ($T_1$) und mindestens zwei Vortransistoren ($T_2$, $T_3$) vorgeschlagen. Die Kollektoren der Vortransistoren ($T_2$, $T_3$) sind an den Kollektor des Endstufentransistors ($T_1$) angeschlossen, während die Emitter der Vortransistoren ($T_2$, $T_3$) an die Basis des Endstufentransistors ($T_1$) angeschlossen sind. Die Basen der Vortransistoren ($T_2$, $T_3$) sind unabhängig voneinander ansteuerbar. Eine Zenerdiode (ZD) ist mit ihrer Anode an die Basis des zweiten Vortransistors ($T_3$) angeschlossen und mit ihrer Kathode mit dem Kollektor des zweiten Vortransistors ($T_3$) verbunden. Die Schaltung kann in monolithisch integrierter Technik hergestellt werden und zeichnet sich durch eine hohe Sperrfähigkeit aus. Sie dient zum Schalten und/oder Regeln hoher Ströme. Sie Schaltung ist gegen elektrische Überspannungen geschützt und weist eine kurze Schaltzeit auf. Man gewinnt mit ihr bei einer monolithischen Darlingtonschaltung durch mindestens einen zusätzlichen Anschluß die Möglichkeit, zur Optimierung der Schaltung verschiedene Arten der Ansteuerung zu realisieren, die sich bei der herkömmlichen Darlingtonschaltung mit drei Anschlüssen gegenseitig ausschließen.

FIG. 4

R. **5825**
Fb/Jä 19.10.1979

Robert Bosch GmbH, 7000 Stuttgart 1

Darlington-Transistorschaltung

## Stand der Technik

Die Erfindung geht aus von einer Darlington-Transistorschaltung nach der Gattung des Hauptanspruchs. Aus der US-PS 3 596 150 ist bereits eine Darlington-Transistorschaltung dieser Art bekannt. Diese Schaltung hat den Nachteil, daß bei ihr der Endstufentransistor nur über einen einzigen Vortransistor angesteuert werden kann.

## Vorteile der Erfindung

Die erfindungsgemäße Darlington-Transistorschaltung mit den kennzeichnenden Merkmalen des Hauptanspruchs hat demgegenüber den Vorteil, daß der Endstufentransistor auch über den zweiten und gegebenenfalls über die weiteren Vortransistoren angesteuert werden kann. Weitere Vorteile ergeben sich aus den Unteransprüchen.

...

Zeichnung

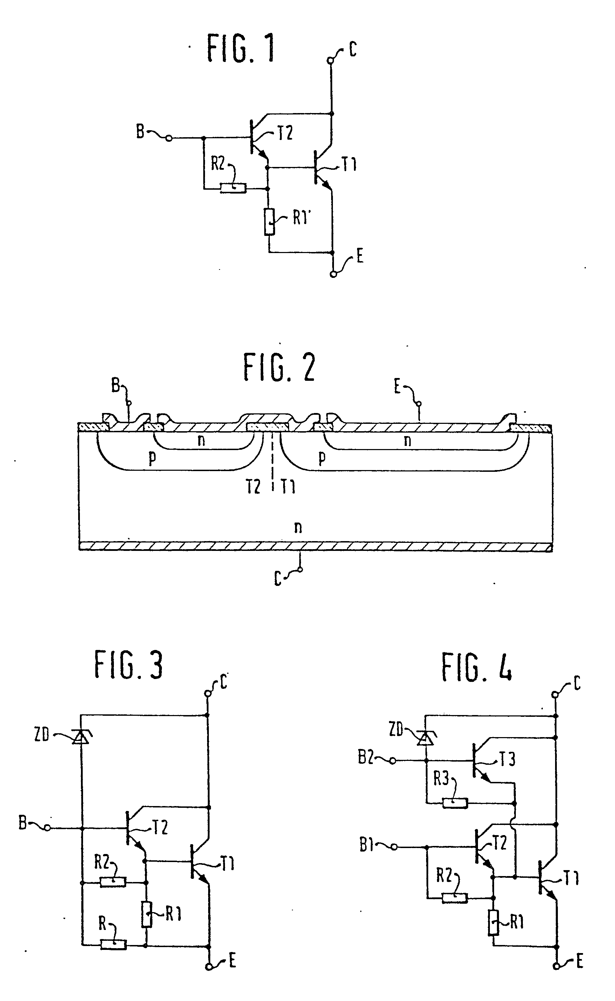

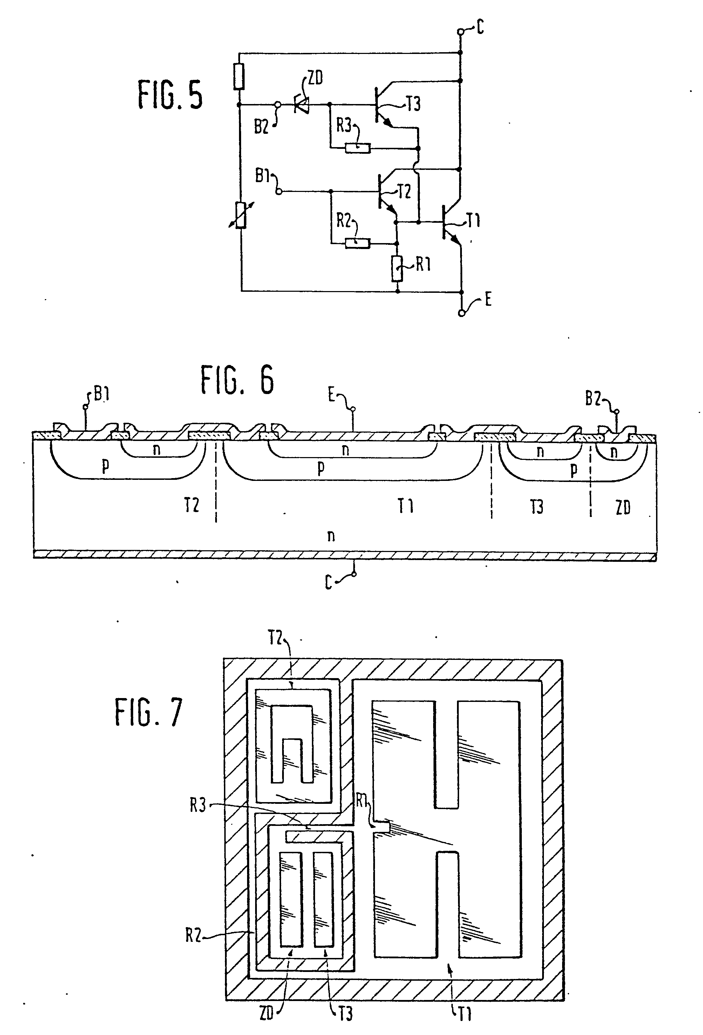

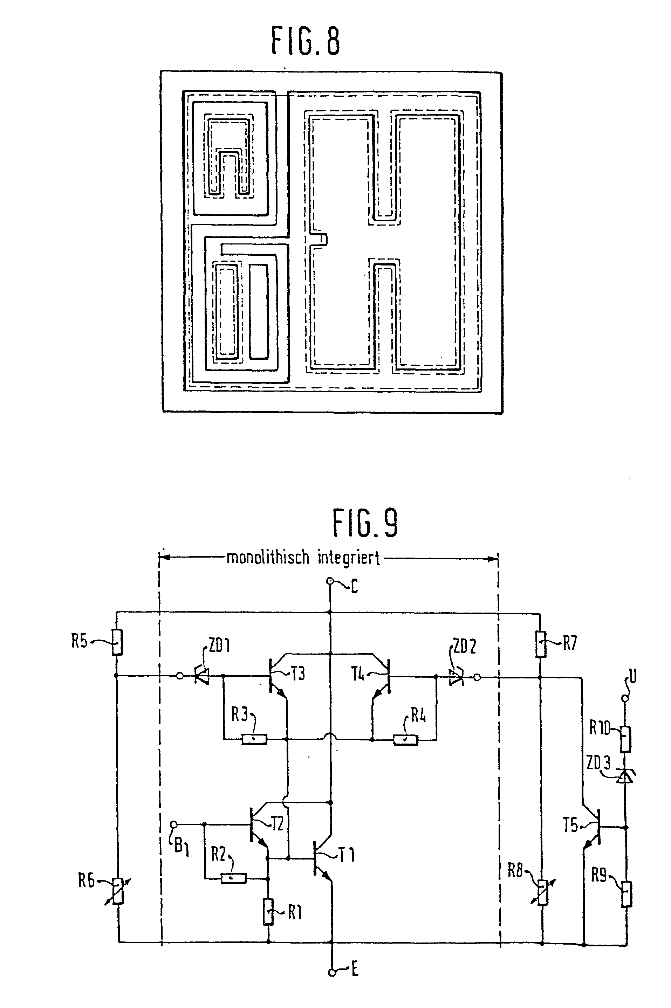

Ausführungsbeispiele der erfindungsgemäßen Darlington-
Transistorschaltung sind in der Zeichnung dargestellt
und in der nachfolgenden Beschreibung näher erläutert.
Es zeigen: Fig. 1 das elektrische Schaltbild einer
Darlington-Transistorschaltung mit einem Endstufentransistor und einem Vortransistor und mit je einem
Widerstand parallel zu den Emitter-Basis-Strecken
dieser beiden Transistoren; Fig. 2 einen Schnitt
durch das Layout einer Darlingtonschaltung nach Fig.
1; Fig. 3 das elektrische Schaltbild einer Anordnung
ähnlich der der Fig. 1; Fig. 4 das elektrische Schaltbild eines ersten Ausführungsbeispiels einer erfindungsgemäßen Darlington-Transistorschaltung; Fig. 5
das elektrische Schaltbild eines zweiten Ausführungsbeispiels einer erfindungsgemäßen Darlington-Transistorschaltung; Fig. 6 einen Schnitt durch eine monolithische Darlingtonschaltung nach Fig. 5; Fig. 7 das
Layout der fertig diffundierten, aber noch nicht metallisierten Darlingtonschaltung nach Fig. 5; Fig. 8
das Layout der fertig diffundierten und metallisierten
Darlingtonschaltung nach Fig. 5; Fig. 9 das elektrische
Schaltbild einer Darlington-Transistorschaltung mit
drei Vortransistoren.

Beschreibung der Ausführungsbeispiele

In vielen Fällen erweist es sich als zweckmäßig,
zum Schalten und/oder Regeln hoher Ströme monolithische
Halbleiteranordnungen mit zwei Transistoren $T_1$ und $T_2$
zu verwenden, die in Darlingtonschaltung miteinander
verbunden sind. Wegen der hohen Gesamtverstärkung

...

ist es nützlich, die Emitter-Basis-Strecken der beiden Transistoren $T_1$ und $T_2$ durch geeignete Widerstände $R_1$ und $R_2$ zu überbrücken, damit die Schaltung nicht durch zu kleine Ströme aufgesteuert werden kann, insbesondere nicht durch die bei erhöhter Temperatur ansteigenden Sperrströme. Eine derartige Anordnung (Fig. 1) kann beispielsweise mit Hilfe der Planartechnik hergestellt werden (Fig. 2). Zum Einbau kann ein Gehäuse mit drei Anschlüssen benutzt werden.

Für die Beispiele werden npn-Darlingtonschaltungen benutzt. Die beschriebenen Darlingtonschaltungen müssen gegen energiereiche Spannungsspitzen zwischen den Anschlüssen C und E geschützt werden, wie sie besonders nach dem Abschalten induktiver Lasten auftreten.

Als Schutz gegen derartige Spannungsspitzen hat sich eine Zenerdiode ZD bewährt, die zwischen die Anschlüsse B und C geschaltet wird, eventuell mit einem zusätzlichen Widerstand R zwischen den Anschlüssen B und E (Fig. 3).

Die Durchbruchspannung der Zenerdiode ZD muß über der im normalen Sperrbetrieb an der Darlingtonschaltung vorkommenden Spannung liegen, aber unterhalb der Spannung $U_{CEO}$. An die Strombelastbarkeit im Durchbruch der Zenerdiode ZD werden im Gegensatz zu der einer etwaigen Zenerdiode zwischen den Anschlüssen C und E keine hohen Ansprüche gestellt. Es genügt ein Strom von der Größenordnung des Basistroms der Darlingtonschaltung. Die Zenerdiode

. . .

ZD wird beispielsweise dann wirksam, wenn nach dem Abschalten des Basisstroms der Darlingtonanordnung der Strom durch eine induktive Last zurückgeht. Bei bestimmten Betriebszuständen wird eine so hohe Spannung induziert, daß die Durchbruchspannung der Zenerdiode ZD überschritten wird. Es fließt ein Sperrstrom, der dazu führt, daß die Basis B gegen den Emitter E positiv wird. Es fließt während der Zeit, in der die Spannungsspitze höher ist als die Zenerspannung, Basisstrom in die Darlingtonanordnung, wodurch ein Einschnüreffekt (pinch-in) am Endstufentransistor $T_1$ verhindert wird.

Die gegen den Emitter E positive Spannung an der Basis B steht aber im Widerspruch zur Forderung nach kurzer Schaltzeit der Darlingtonanordnung. Wenn nämlich in der Ausschaltphase die Basis B negativ gegen den Emitter E wird oder gegen den Emitter E kurzgeschlossen oder wenigstens auf ein in Vergleich zu einer Emitter-Basis-Flußspannung kleines positives Potential gebracht wird, können zumindest die im Basis- und Kollektorgebiet des Transistors $T_2$ während der vorausgegangenen Einschaltphase gespeicherten Ladungsträger schneller abgeführt werden. In diesem Falle ist die Schaltzeit der Darlingtonanordnung deutlich kürzer als im Falle der in Fig. 3 dargestellten Anordnung. Das Problem kann erfindungsgemäß dadurch gelöst werden, daß die Darlingtonanordnung einen weiterern Vortransistor $T_3$ erhält, der mit den Transistoren $T_1$ und $T_2$ eine gemeinsame Kollektorzone besitzt, dessen Emitterzone wie die des Transistors $T_2$ mit der Basiszone des Transistors $T_1$ verbunden wird und dessen

...

Basiszone von außen zugänglich ist. Es ist zweckmäßig, die Emitter-Basis-Strecke des Transistors
$T_3$ durch einen Widerstand $R_3$ zu überbrücken. Fig. 4
zeigt ein Beispiel für eine erfindungsgemäße Anordnung.

Der Anschluß $B_1$ ist der für den eigentlichen Schaltbetrieb benötigte Basisanschluß der Darlingtonanordnung. Sein Potential kann beim Abschalten so gelegt
werden, wie es für eine kurze Schaltzeit erforderlich
ist. Der Basisanschluß $B_2$ des zweiten Vortransistors
$T_3$ wird über eine Zenerdiode ZD mit dem Anschluß C
verbunden.

Eine Weiterführung der Erfindung besteht darin,
die von außen zugeschaltete Zenerdiode ZD wegzulassen und dafür in das p-Gebiet des Vortransistors
$T_3$ neben dem Emitter-n-Gebiet ein zweites n-Gebiet
gleichzeitig einzubringen. Der Anschluß $B_2$ wird in
dieses Gebiet gelegt. Damit Basisstrom in den Transistor $T_3$ fließt, muß die Spannung zwischen den Anschlüssen $B_2$ und E außer dem üblichen Wert von ca.
1,5 V zusätzlich die Durchbruchspannung des durch das
zweite n-Gebiet gebildeten pn-Übergangs übersteigen.
Man erhält so ohne zusätzliche Kosten eine integrierte Zenerdiode zwischen dem Anschluß $B_2$ und der
eigentlichen Basis des Transistors $T_3$. Da die Sperrspannung dieser Diode nur von der Größenordnung
10 bis 20 V ist, muß man sie über einen Spannungsteiler zwischen den Anschlüssen C und E anschließen,
der so abzugleichen ist, daß beim Überschreiten
einer gewünschten Schwellspannung zwischen den Anschlüssen C und E Basisstrom in den Transistor $T_3$
fließt (Fig. 5). Die Schaltungsanordnung der Fig. 5

...

- 6 -

wird, abgesehen von dem Spannungsteiler, monolithisch integriert. Fig. 6 zeigt einen schematischen Querschnitt durch eine Anordnung. Die Figuren 7 und 8 zeigen schematisch, wie mit Hilfe eines Planarprozesses die erfindungsgemäße Anordnung hergestellt werden kann.

Als Halbleiterkörper dient monokristallines Silizium mit geeignetem spezifischen Widerstand und geeigneter Dicke. In die in Fig. 7 nicht schräg schraffierten Gebiete wird Bor eindiffundiert. Die so erzeugten Basiszonen der Transistoren $T_1$, $T_2$ und $T_3$ sind nicht völlig voneinander isoliert, sondern es bestehen schmale Verbindungen zwischen den Transistoren $T_1$ und $T_2$ sowie zwischen den Transistoren $T_1$ und $T_3$. Diese Verbindungen stellen, wenn später die Emitterzonen der Transistoren $T_2$ und $T_3$ mit der Basiszone des Transistors $T_1$ durch Metall verbunden sind, im wesentlichen die Widerstände $R_2$ und $R_3$ dar. In die in Fig. 7 grau gezeichneten Gebiete wird Phosphor eindiffundiert. Eine Ausbuchtung der p-leitenden Basiszone des Transistors $T_1$ in seine n-leitende Emitterzone, an deren Ende der pn-Übergang später durch Metall kurzgeschlossen wird, stellt den Widerstand $R_1$ dar. Nach Öffnen der Kontaktfenster im $SiO_2$ wird auf der Vorderseite und der Rückseite des Halbleiterkörpers eine geeignete Metallisierung aufgebracht, beispielsweise durch Aufdampfen unter Hochvakuum. In den in der Fig. 8 weißen Gebieten wird mittels eines photolitographischen Prozesses das Metall wieder entfernt. Die Kontaktfenster sind der Übersichtlichkeit halber nicht eingezeichnet, aber es geht aus Fig. 6 hervor, wo das Metall

...

- 7 -

Verbindung mit dem Silizium haben muß und wo es durch $SiO_2$ gegen das Silizium isoliert verlaufen muß. Aus den Zeichnungen geht auch nicht hervor, daß, wie für den Fachmann selbstverständlich ist, die Kollektorzone unter der Metallisierung hoch dotiert sein muß.

Die Erfindung muß nicht auf zwei Vortransistoren beschränkt bleiben. Man kann sich auch, wie in Fig. 9 dargestellt, eine gegenüber der in Fig. 5 abgebildeten Schaltung um einen dritten Vortransistor erweiterte Schaltung vorstellen. Dieser Transistor $T_4$ wird mit dem Widerstand $R_4$ und der Zenerdiode $ZD_2$ in gleicher Weise hergestellt wie der Transistor $T_3$ mit dem Widerstand $R_3$ und der Zenerdiode $ZD_1$. Der aus den Widerständen $R_7$ und $R_8$ bestehende Spannungsteiler ist aber so eingestellt, daß im Transistor $T_4$ bei einer wesentlich niedrigeren Spannung zwischen den Anschlüssen C und E Basisstrom fließt als im Transistor $T_3$, das aber nur, wenn eine zusätzliche Bedingung erfüllt ist, nämlich, daß die Spannung U einen durch die Zenerdiode $ZD_3$ bestimmten Wert unterschreitet. Ist die Spannung U höher, wird der Transistor $T_5$ eingeschaltet, der Widerstand $R_8$ wird dadurch praktisch kurzgeschlossen, und der Transistor $T_4$ wird unwirksam, da in seine Basis kein Strom fließen kann.

R.5 8 2 5
Fb/Jä 19.10.1979


Robert Bosch GmbH, 7000 Stuttgart 1


Ansprüche


1. Darlington-Transistorschaltung mit einem Endstufentransistor ($T_1$) und einem Vortransistor ($T_2$), dessen Kollektor an den Kollektor des Endstufentransistors ($T_1$) und dessen Emitter an die Basis des Endstufentransistors ($T_1$) angeschlossen ist, dadurch gekennzeichnet, daß ein zweiter Vortransistor ($T_3$) und gegebenenfalls weitere Vortransistoren vorgesehen sind, deren Kollektoren an den Kollektor des Endstufentransistors ($T_1$) und deren Emitter an die Basis des Endstufentransistors ($T_1$) angeschlossen sind, und daß die Basen der Vortransistoren ($T_2$, $T_3$, $T_4$) unabhängig voneinander ansteuerbar sind.


2. Darlington-Transistorschaltung nach Anspruch 1, dadurch gekennzeichnet, daß der erste Vortransistor ($T_2$) im eingeschalteten Zustand der Dar-


...

lington-Transistorschaltung den Basisstrom für den Endstufentransistor ($T_1$) liefert.

3. Darlington-Transistorschaltung nach Anspruch 2, dadurch gekennzeichnet, daß die Basis des ersten Vortransistors ($T_2$) gegen den Emitter kurzschließbar ist oder daß an diese Basis gegenüber dem Emitter ein negatives Potential anlegbar ist, um beim Ausschalten der Darlington-Transistorschaltung die Schaltzeit zu verkürzen.

4. Darlington-Transistorschaltung nach mindestens einem der Ansprüche 1 bis 3, dadurch gekennzeichnet, daß eine Zenerdiode (ZD) mit ihrer Anode an die Basis des zweiten Vortransistors ($T_3$) angeschlossen und mit ihrer Kathode mit dem Kollektor des zweiten Vortransistors ($T_3$) verbunden ist, damit beim Überschreiten einer gewissen Spannung zwischen dem Kollektor und dem Emitter des Endstufentransistors ($T_1$) der zweite Vortransistor ($T_3$) und damit auch der Endstufentransistor ($T_1$) aufgesteuert wird.

5. Darlington-Transistorschaltung nach Anspruch 4, dadurch gekennzeichnet, daß ein aus zwei ohmschen Widerständen bestehender Spannungsteiler zwischen den Kollektor und den Emitter des Endstufentransi-

...

stors ($T_1$) gelegt ist und daß die Kathode der Zenerdiode (ZD) an den Abgriff dieses Spannungsteilers angeschlossen ist, um die gewünschte Klammerspannung einzustellen, bei der die Zenerdiode (ZD) leitend wird.

6. Darlington-Transistorschaltung nach mindestens einem der Ansprüche 2 bis 5, dadurch gekennzeichnet, daß mindestens der Endstufentransistor ($T_1$) und die Vortransistoren ($T_2$, $T_3$, $T_4$) miteinander mono- lithisch integriert sind.

7. Darlington-Transistorenschaltung nach Anspruch 6, dadurch gekennzeichnet, daß die Zenerdiode (ZD) in die Schaltung monolitisch integriert ist, indem die Basiszone des zweiten Vortransistors ($T_3$) über eine innerhalb dieser Basiszone befindliche Zone entgegengesetzter Leitfähigkeit angesteuert wird, so daß bei diesem Vortransistor ($T_3$), abgesehen von einem geringen Sperrstrom, zwischen Basis und Emitter erst nach Überschreiten der Durchbruchspannung des pn-Übergangs zwischen der genannten Zone und der Basiszone Strom fließt.

8. Darlington-Transistorschaltung nach mindestens

. . .

einem der Ansprüche 1 bis 7, dadurch gekennzeichnet, daß die Emitter-Basis-Strecken aller Einzeltransistoren ($T_1$, $T_2$, $T_3$, $T_4$) durch Widerstände überbrückt sind.

9. Verfahren zur Herstellung einer Darlington-Transistorschaltung nach Anspruch 7, dadurch gekennzeichnet, daß die innerhalb der Basiszone befindliche, zur Ansteuerung dienende Zone in einem Arbeitsgang mit den Emitterzonen hergestellt wird.

## FIG. 1

## FIG. 2

## FIG. 3

## FIG. 4

FIG. 5

FIG. 6

FIG. 7

## FIG.8

## FIG.9

monolithisch integriert